# EUROPEAN PATENT APPLICATION

(11) **EP 4 383 315 A1**
(43) Date of publication of application: **12.06.2024**
(21) Application number: 22853114.1
(22) Date of filing: 03.08.2022
(51) Int. Cl.: H01L 21/365, C23C 16/40, C30B 25/02, C30B 29/16, H01L 21/20, H01L 29/24

(54) **SEMICONDUCTOR SUBSTRATE, SEMICONDUCTOR WAFER, AND METHOD FOR MANUFACTURING SEMICONDUCTOR WAFER**

(30) Priority: 06.08.2021 JP 2021129837
(71) Applicant: Tamura Corporation, Tokyo 178-8511 (JP); Novel Crystal Technology, Inc., Sayama-shi, Saitama 350-1328 (JP)
(72) Inventor: SASAKI, Kohei, Sayama-shi, Saitama 350-1328 (JP); LIN, Chia-Hung, Sayama-shi, Saitama 350-1328 (JP)
(74) Representative: Betten & Resch
(86) International application number: PCT/JP2022/029844
(87) International publication number: WO 2023/013696

(57) **Abstract**

Provided is a gallium oxide-based semiconductor substrate configured to allow the formation, by HVPE, of a gallium oxide-based epitaxial film having a small film thickness distribution, a small donor concentration distribution, and a low crystal defect density. Also provided are a semiconductor wafer including the semiconductor substrate and the epitaxial film, and a method for manufacturing the semiconductor wafer. As one embodiment, provided is a semiconductor substrate 10 in which at least one main surface thereof is a crystal growth base surface 11. The semiconductor substrate 10 comprises a single crystal of a gallium oxide-based semiconductor. The growth base surface 11 is the (001) plane. In a continuous region of 70 area% or more of the growth base surface 11, the off angle in the [010] direction is in the range from greater than -0.3° to -0.01°, or in the range from 0.01° to smaller than 0.3°. In said region of the growth base surface 11, the off angle in the [001] direction is in the range from -1° to 1°. The diameter of the semiconductor substrate 10 is 2 inches or more.

## Description

### Technical Field

The present invention relates to a semiconductor substrate, a semiconductor wafer, and a method for manufacturing a semiconductor wafer.

### Background Art

An invention for epitaxially growing a gallium oxide-based single crystal film on a substrate formed of a gallium oxide-based single crystal by the HVPE (Halide Vapor Phase Epitaxy) method is known (see, e.g., Patent Literature 1). According to the invention described in Patent Literature 1, the growth rate of the epitaxial film by the HVPE method can be increased by setting the orientation of the main surface of the substrate to a predetermined orientation.

### Citation List

### Patent Literatures

Patent Literature 1: JP 2017/109902 A

### Summary of Invention

The problem of gallium oxide-based epitaxial wafers with a diameter of not less than 2 inches manufactured using the known techniques is that the epitaxial film has a large thickness distribution of 11% and a large donor concentration distribution (the donor distribution is not less than 40% when no donor is intentionally added). Meanwhile, when the film deposition is performed under conditions under which the film thickness distribution becomes small, the density of crystal defects caused by epitaxial growth and appeared as etch pits is as high as not less than 5×10⁴ cm⁻³. Due to these problems, it is difficult to manufacture gallium oxide-based power devices with high yields when using the known gallium oxide-based epitaxial wafers.

Therefore, it is an object of the invention to provide a gallium oxide-based semiconductor substrate on which a gallium oxide-based epitaxial film having a small film thickness distribution, a small donor concentration distribution, and a low crystal defect density can be deposited by the HVPE method, and also to provide a semiconductor wafer including such semiconductor substrate and epitaxial film, and a method for manufacturing such a semiconductor wafer.

To achieve the above-mentioned object, an aspect of the present invention provides a semiconductor substrate defined in (1) below, a semiconductor wafer defined in (2) to (5) below, and a method for manufacturing a semiconductor wafer defined in (6) below.
(1) A semiconductor substrate, comprising:
   at least one main surface as a crystal growth base surface; and
   a gallium oxide-based semiconductor single crystal,
      wherein the growth base surface is a (001) plane,
      wherein an off angle in a [010] direction in a continuous region of not less than 70 area% of the growth base surface is in a range of more than -0.3° and not more than -0.01°, or in a range of not less than 0.01° and less than 0.3°,
      wherein an off angle in a [001] direction in the region of the growth base surface is in a range of not less than -1° and not more than 1°, and
   wherein the semiconductor substrate has a diameter of not less than 2 inches.
(2) A semiconductor wafer, comprising:
   the semiconductor substrate defined in (1) above; and
   an epitaxial film on the growth base surface of the semiconductor substrate, the epitaxial film comprising a single crystal of a gallium oxide-based semiconductor which comprises Cl derived from a raw material of the HVPE method,
   wherein a density of crystal defects appearing as etch pits in the epitaxial film is less than 5×10⁴ cm⁻³.
(3) The semiconductor wafer defined in (2) above, wherein the epitaxial film is in an as-grown state, and wherein a film thickness distribution in a continuous region of not less than 70 area% of the epitaxial film is less than ±10%.
(4) The semiconductor wafer defined in (2) or (3) above, wherein the epitaxial film does not include an intentionally added donor, and wherein a donor concentration distribution in the epitaxial film is less than ±40%.
(5) The semiconductor wafer defined in any one of (2) to (4) above, wherein an in-plane density of pits reaching from the surface of the epitaxial film to a surface of the semiconductor substrate in a continuous region of not less than 70 area% of a surface of the epitaxial film is not more than 0.1 pit/cm².
(6) A method for manufacturing a semiconductor wafer, comprising:
   preparing a semiconductor substrate comprising at least one main surface as a crystal growth base surface, the semiconductor substrate comprising a gallium oxide-based semiconductor single crystal and having a diameter of not less than 2 inches; and
   forming an epitaxial film by epitaxially growing a gallium oxide-based semiconductor single crystal on the growth base surface of the semiconductor substrate using a HVPE method,
   wherein the growth base surface is a (001) plane,
   wherein an off angle in a [010] direction in a continuous region of not less than 70 area% of the growth base surface is in a range of more than -0.3° and not more than -0.01°, or in a range of not less than 0.01° and less than 0.3°, and
   wherein an off angle in a [001] direction in the region of the growth base surface is in a range of not less than -1° and not more than 1°.

### Advantageous Effects of Invention

According to the invention, it is possible to provide a gallium oxide-based semiconductor substrate on which a gallium oxide-based epitaxial film having a small film thickness distribution, a small donor concentration distribution, and a low crystal defect density can be deposited by the HVPE method, and also possible to provide a semiconductor wafer including such semiconductor substrate and epitaxial film, and a method for manufacturing such a semiconductor wafer.

### Brief Description of Drawings

FIG. 1 is a vertical cross-sectional view showing a semiconductor wafer in an embodiment of the present invention.
FIG. 2A is a photograph of a semiconductor wafer manufactured with a set value of 0° for an off angle in the [010] direction of a growth base surface when photographed from the surface side of an epitaxial film.
FIG. 2B is a photograph of a semiconductor wafer manufactured with a set value of 0° for the off angle in the [010] direction of the growth base surface when photographed from the surface side of the epitaxial film.
FIG. 3 is a photograph of a semiconductor wafer manufactured with a set value of 0° for the off angle in the [010] direction of the growth base surface when photographed from the surface side of the epitaxial film.
FIG. 4 is a photograph of a semiconductor wafer manufactured with a set value of 0.1° for the off angle in the [010] direction of the growth base surface when photographed from the surface side of the epitaxial film.
FIG. 5A is a plan view showing a film thickness distribution of a Ga₂O₃ film deposited on a sapphire substrate by the HVPE method.
FIG. 5B is a plan view showing the film thickness distribution of the Ga₂O₃ film on the sapphire substrate, with the film thickness at the center normalized to 1.00.
FIG. 6 is a plan view showing a film thickness distribution of the epitaxial film shown in FIG. 2B, which is corrected using the normalized film thickness distribution of the Ga₂O₃ film on the sapphire substrate.
FIG. 7 is a graph showing measured values of the donor concentration in a region with linear morphology and a region without linear morphology for twenty-five epitaxial films.

### Description of Embodiments

### (Embodiment)

### (Configuration of a semiconductor wafer)

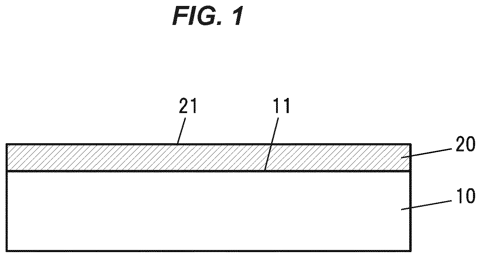

FIG. 1 is a vertical cross-sectional view showing a semiconductor wafer 1 in an embodiment of the invention. The semiconductor wafer 1 has a semiconductor substrate 10 formed of a single crystal of a gallium oxide-based semiconductor, and an epitaxial film 20 formed of a single crystal of a gallium oxide-based semiconductor and located on a growth base surface 11 of the semiconductor substrate 10 by epitaxial growth.

The gallium oxide-based semiconductor here is Ga₂O₃ or is Ga₂O₃ doped with elements such as Al and In. The gallium oxide-based semiconductor has a composition represented by, e.g., (GaₓAl_{y}In_{(1-x-y)})₂O₃ (0<x≤1, 0≤y≤1, 0<x+y≤1). Ga₂O₃ has a wider band gap when doped with Al and a narrower band gap when doped with In.

The single crystals of gallium oxide-based semiconductors constituting the semiconductor substrate 10 and the epitaxial film 20 have a β-crystal structure. The semiconductor substrate 10 and the epitaxial film 20 may also include a dopant such as Si or Sn.

The semiconductor substrate 10 is a substrate used as a base substrate for epitaxial crystal growth using the HVPE method. To form the semiconductor substrate 10, e.g., a bulk crystal of a Ga₂O₃-based single crystal grown by a melt-growth technique such as the FZ (Floating Zone) method or the EFG (Edge Defined Film Fed Growth) method is sliced and the surface thereof is then polished.

The semiconductor film 20 is deposited by the HVPE method using Cl-containing gas. Therefore, the epitaxial film 20 includes Cl derived from the raw material of the HVPE method. A concentration of Cl included in the epitaxial film 20 is not more than 5×10¹⁶ atoms/cm³. When oxide-based semiconductor epitaxial films are formed by a method other than the HVPE method, a raw material containing Cl is not used, hence, epitaxial films usually do not include Cl, or at least do not include not less than 1×10¹⁶ cm⁻³ of Cl.

Source gases used for the epitaxial film 20 are a Ga source gas which is a Ga chloride gas such as GaCl gas, GaCl₂ gas, GaCl₃ gas or (GaCl₃)₂ gas, an O source gas which is an oxygen-containing gas such as O₂ gas or H₂O gas, and a dopant source gas which is a dopant-containing gas such as SiCl₄ gas, GeCl₄ gas, SnCl₄ gas or PbCl₂ gas. When the epitaxial film 20 includes Al or In, an Al source gas, which is an Al chloride gas such as AlCl, or an In source gas, which is an In chloride gas such as InCl, is also used.

The epitaxial film 20 is formed by the HVPE method with a high crystal growth rate, and thus can be formed thick, e.g., can be formed to have a thickness of not less than 1000 nm. The growth rate of the epitaxial film 20 by the industrial HVPE method is about 200 µm/h, and in this case, a film of up to 1000 µm in thickness can be deposited in a realistic time. In other words, it is possible to form the epitaxial film 20 having a thickness of, e.g., not less than 1000 nm and not more than 1000 µm. In this regard, use of the MBE method is not realistic in actual production since a crystal growth rate of the gallium oxide-based semiconductor epitaxial film is about 120 nm/h and it requires not less than 8 hours to form a film of not less than 1000 nm in thickness.

At least one of main surfaces of the semiconductor substrate 10 serves as a crystal growth base surface 11. The growth base surface 11 of the semiconductor substrate 10 is a (001) plane. In a continuous region of not less than 70 area% of the growth base surface 11 (a continuous region having an area of not less than 70% of the entire growth base surface 11), an off angle in the [010] direction (an inclination angle from the (001) plane) is in a range of more than -0.3° and not more than -0.01°, or in a range of not less than 0.01° and less than 0.3°. Preferably in a contiguous region of not less than 80 area% of the growth base surface 11, more preferably in a contiguous region of not less than 90 area% of the growth base surface 11, the off angle in the [010] direction (the inclination angle from the (001) plane) is in a range of more than -0.3° and not more than -0.01°, or in a range of not less than 0.01° and less than 0.3°. In addition, in a region where the off angle in the [010] direction (the inclination angle from the (001) plane) is in the range of more than -0.3° and not more than -0.01° or in the range of not less than 0.01° and less than 0.3°, an off angle in the [001] direction is in a range of not less than -1° and not more than 1°.

The off angle of the growth base surface 11 can be measured using an atomic force microscope. In particular, observation of the growth base surface 11 with an atomic force microscope provides information on the step-and-terrace structure in which the terrace is in the (001) plane, and the off angle can be obtained from the length of the terrace and the height of the step by using a trigonometric function.

When there is a region in which the off angle in the [001] direction of the growth base substrate 11 is in a range of more than -0.01° and less than 0.01°, linear morphology spreads from a portion of a surface 21 of the epitaxial film 20 which is located on that region.

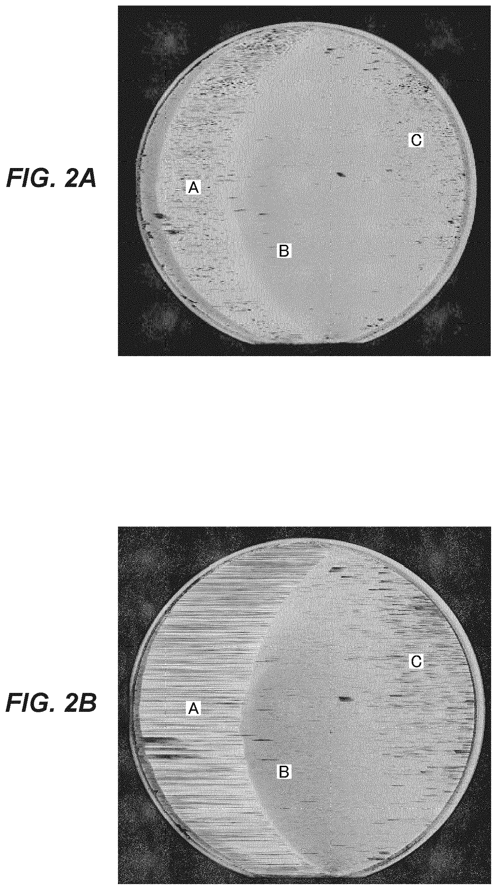

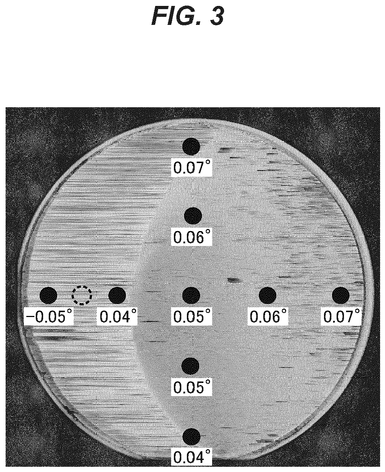

FIGS. 2A, 2B and FIG. 3 are photographs of the semiconductor wafers 1 when photographed from the surface 21 side of the epitaxial film 20. The epitaxial films 20 shown in FIGS. 2A and 2B are Ga₂O₃ films formed under the same conditions that can suppress powder accumulation (described later), and respectively have thicknesses of 3 µm and 6 µm. On the surface 21 of the epitaxial film 20 shown in FIGS. 2A and 2B, a region A is a region with linear morphology, a region B is a black rough region, and a region C is a white rough region.

In FIG. 3, values of the off angle in the [010] direction at nine points on the growth base surface 11 of the semiconductor substrate 10 under the epitaxial film 20 are shown on the photograph of the semiconductor wafer 1 shown in FIG. 2B. A region surrounded by a dashed circle in FIG. 3 is a region where the off angle of the growth base surface 11 is close to 0°. In this regard, the semiconductor substrates 10 of the semiconductor wafers 1 shown in FIGS. 2A, 2B and 3 are manufactured by setting the off angle of the growth base surface 11 in the [010] direction to 0° (no off angle), and the off angle distribution is caused by processing errors in slicing and polishing processes or twisting of gallium oxide-based single crystal.

FIGS. 2A, 2B and 3 show that the linear morphology of the surface 21 of the epitaxial film 20 spreads from a portion grown on the region where the off angle of the growing base surface 11 is close to 0°.

The deposition rate is low at a portion with linear morphology on the surface 21 of the epitaxial film 20. Therefore, if the surface 21 includes a mixture of the portion with linear morphology and the portion without linear morphology, the film thickness distribution of the epitaxial film 20 becomes large. In addition, the epitaxial film 20 has a higher donor concentration at the portion with linear morphology. The increase in the donor concentration is presumed to be caused by Cl which is included in the raw material of the HVPE method and is unintentionally incorporated.

When the off angle in the [010] direction of the growth base surface 11 of the semiconductor substrate 10 is not more than -0.01° or not less than 0.01°, occurrence of linear morphology on the surface 21 of the epitaxial film 20 can be suppressed and in-plane variation in the deposition rate of the epitaxial film 20 can thus be suppressed. Therefore, the film thickness distribution of the epitaxial film 20 in the as-grown state (as-grown without polishing, etc.) is suppressed to less than ±10% (the deviation of the thicknesses of the thickest and thinnest portions from their central value is less than ±10% of the central value, i.e., the absolute value of the difference between the thickness of the thickest or thinnest portion and the central value is less than 10% of the central value). Since the off angle in the [010] direction of the growth base surface 11 in a continuous region of not less than 70 area% (preferably not less than 80 area%, more preferably not less than 90 area%) is not more than -0.01° or not less than 0.01°, the film thickness distribution of the as-grown epitaxial film 20 is less than ±10% in a continuous region of not less than 70 area% (preferably not less than 80 area%, more preferably not less than 90 area%). In this regard, the film thickness of the epitaxial film 20 can be measured by a Fourier-transform infrared spectrophotometer (FT-IR).

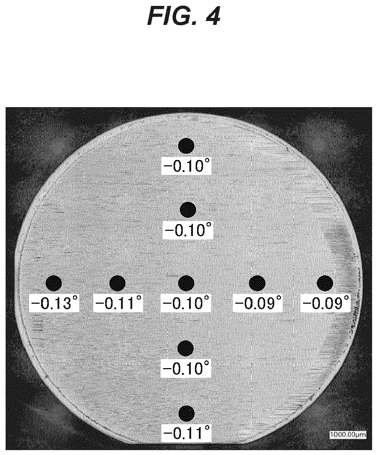

FIG. 4 is a photograph of the semiconductor wafer 1 manufactured with a set value of 0.1° for the off angle in the [010] direction of the growth base surface 11 when photographed from the surface 21 side of the epitaxial film 20. In the semiconductor wafer 1 shown in FIG. 4, the off angle in the [010] direction of the growth base surface 11 of the semiconductor substrate 10 at the nine points shown in the drawing is not more than -0.01°, and a majority region of the growth base surface 11 including those nine points is a white rough region (a region not having linear morphology).

When using the conditions under which Ga oxide powder is produced in the gas phase due to the gas-phase reaction of the source gas during film deposition and adheres to the growth base substrate 11 (hereinafter, referred to as "powder accumulation"), the Ga oxide powder falls and accumulates evenly on the growth base substrate 11, hence, in-plane variation in the film thickness of the epitaxial film 20 caused by the off angle of the growth base surface 11 can be reduced. However, semiconductor wafers manufactured under conditions causing powder accumulation cannot be put to practical use since the density of crystal defects appearing as etch pits increases to not less than 5×10⁴ cm⁻³ due to powder accumulation and this causes problems such as a decrease in breakdown voltage of devices manufactured from the semiconductor wafers.

The density of crystal defects appearing as etch pits described above is obtained by etching the semiconductor wafer 1 for 30 minutes using a 10% KOH solution heated to 85°C and measuring the density of etch pits appeared on the surface of the epitaxial film 20 using a differential interference microscope.

The density of crystal defects caused by epitaxial growth and appearing as etch pits is less than 5×10⁴ cm⁻³ when the film thickness distribution in a predetermined region of the epitaxial film 20 is suppressed to less than ±10% by setting the off angle in the [010] direction in a predetermined region of the growth base surface 11 of the semiconductor substrate 10 to not more than -0.01° or not less than 0.01° and depositing the epitaxial film 20 without using the conditions causing powder accumulation.

In addition, when the off angle in the [010] direction of the growth base surface 11 of the semiconductor substrate 10 is not more than -0.01° or not less than 0.01°, almost no linear morphology is observed on the surface 21 of the epitaxial film 20 and unintentional incorporation of Cl is suppressed. Therefore, in case that the epitaxial film 20 is intentionally doped with a donor, the donor concentration can be controlled more accurately. In case that the epitaxial film 20 is not intentionally dope with a donor, the donor concentration distribution in the epitaxial film 20 is less than ±40% (the deviation of the concentrations in the highest- and lowest-concentration portions from their central value is less than ±40% of the central value, i.e., the absolute value of the difference between the concentration in the highest- or lowest-concentration portion and the central value is less than 40% of the central value). Since the off angle in the [010] direction of the growth base surface 11 in a continuous region of not less than 70 area% (preferably not less than 80 area%, more preferably not less than 90 area%) is not more than -0.01° or not less than 0.01°, the donor concentration distribution is less than ±40% in a continuous region of not less than 70 area% (preferably not less than 80 area%, more preferably not less than 90 area%) of the epitaxial film 20 when the epitaxial film 20 is not intentionally dope with a donor. The donor concentration in the epitaxial film 20 can be determined by capacitance measurement (C-V measurement).

When there is a region in which the off angle in the [010] direction of the growth base surface 11 of the semiconductor substrate 10 is not more than -0.3° or not less than 0.3°, deep pits reaching from the surface 21 of the epitaxial film 20 to the semiconductor substrate 10 (hereinafter, referred to as "through-pits") are likely to occur in such a region.

When the off angle in the [010] direction of the growth base surface 11 of the semiconductor substrate 10 is in a range of more than -0.3° and less than 0.3°, the in-plane density of through-pits on the surface 21 of the epitaxial film 20 is suppressed to not more than 0.1 pits/cm². Since the off angle in the [010] direction of the growth base surface 11 in a continuous region of not less than 70 area% (preferably not less than 80 area%, more preferably not less than 90 area%) is in the range of more than -0.3° and less than 0.3°, the in-plane density of through-pits is not more than 0.1 pits/cm² in a continuous region of not less than 70 area% (preferably not less than 80 area%, more preferably not less than 90 area%) of the surface 21 of the epitaxial film 20. The in-plane density of through-pits included in the epitaxial film 20 can be measured using an optical microscope.

The various effects obtained by satisfying the condition of "the off angle in the [010] direction (the inclination angle from the (001) plane) is in a range of more than -0.3° and not more than -0.01° or in a range of not less than 0.01° and less than 0.3° in a continuous region of not less than 70 area% (preferably not less than 80 area%, more preferably not less than 90 area%) of the growth base surface 11" described above are achieved at least when the off angle in the [001] direction in that region is in a range of not less than -1° and not more than 1°.

When the diameter of the semiconductor substrate 10 is larger, it is more difficult to satisfy the condition of "the off angle in the [010] direction (the inclination angle from the (001) plane) is in a range of more than -0.3° and not more than -0.01° or in a range of not less than 0.01° and less than 0.3° in a continuous region of not less than 70 area% (preferably not less than 80 area%, more preferably not less than 90 area%) of the growth base surface 11", but the semiconductor substrate 10 satisfies this condition even when having a size of not less than 2 inches. In addition, it is possible to manufacture the semiconductor substrate 10 which at least satisfies this condition and has a diameter of up to 8 inches.

### (Method for manufacturing the semiconductor wafer)

The method for manufacturing the semiconductor wafer 1 in the embodiment of the invention includes a step of preparing the semiconductor substrate 10 with at least one main surface serving as the crystal growth base surface 11, which is formed of a single crystal of a gallium oxide-based semiconductor and has a diameter of not less than 2 inches, and a step of forming the epitaxial film 20 by epitaxially growing a single crystal of a gallium oxide-based semiconductor on the growth base surface 11 of the semiconductor substrate 10 using the HVPE method.

In the step of forming the epitaxial film 20, pressure and temperature in a space in a reaction chamber of an HVPE apparatus where the semiconductor substrate 10 is placed are maintained respectively at, e.g., 0.5 to 1.5 atm and 900 to 1100°C, the Ga source gas and the O source gas (additionally, the Al source gas when Al is included in the epitaxial film 20, the In source gas source when In is included, and the dopant source gas when a dopant is included) are supplied together with an inert gas as a carrier gas into the space, and a single crystal of a gallium oxide-based semiconductor is epitaxially grown on the growth base surface 11 of the semiconductor substrate 10.

Here, by forming the epitaxial film 20 at, e.g., a GaCl partial pressure of not more than 1.5×10⁻³ atm, a VI/III ratio (a supply ratio of GaCl to O) of 10, and a linear velocity of the gas inside the reaction chamber of not less than 150 cm/s, occurrence of powder accumulation mentioned above can be suppressed and the density of crystal defects caused by epitaxial growth and appearing as etch pits in the epitaxial film 20 can be reduced to less than 5×10⁴ cm⁻³.

In addition, a GaCl gas is preferably used as the Ga chloride gas which is the Ga source gas. The temperature at which a driving force for growth of Ga₂O₃-based semiconductor single crystal is maintained is the highest with the GaCl gas among Ga chloride gases. To obtain a high-purity, high-quality Ga₂O₃-based semiconductor single crystal, growth at a high growth temperature is effective, hence, it is preferable to use the GaCl gas which has a high growth driving force at high temperatures.

Meanwhile, as the dopant source gas, it is preferable to use a chloride-based gas to suppress unintentional inclusion of other impurities, and when, e.g., Si, Ge, Sn or Pb, which are Group 14 elements, is used as a dopant, a chloride-based gas used is respectively SiCl₄, GeCl₄, SnCl₄ or PbCl₂, etc. In addition, the chloride-based gas is not limited to those compounded with only chlorine, and, e.g., a silane-based gas such as SiHCl₃ may be used.

Meanwhile, if hydrogen is contained in an atmosphere during forming the epitaxial film 20, flatness of the surface 21 of the epitaxial film 20 and a driving force for crystal growth decrease. Therefore, it is preferable that an O₂ gas not containing hydrogen be used as the O source gas.

### (Effects of the embodiment)

According to the embodiment described above, by setting the off angle of the growth base surface 11 of the semiconductor substrate 10 within a predetermined range, the epitaxial film 20 having a small film thickness distribution, a small donor concentration distribution, and a low crystal defect density can be deposited by the HVPE method.

The manufacturing yield of semiconductor devices is generally required to be not less than 60% of wafer surface, but to achieve this, the effective area of the wafer (the area that can be used to manufacture semiconductor devices) is required to be even larger than 60%, e.g., not less than 70%. In the semiconductor wafer 1, since the off angle in the [010] direction (the inclination angle from the (001) plane) is in the range of more than -0.3° and not more than - 0.01° or in the range of not less than 0.01° and less than 0.3° in a continuous region of not less than 70 area% (preferably not less than 80 area%, more preferably not less than 90 area%) of the growth base surface 11, the thickness distribution, the donor concentration distribution and the in-plane density of through pits are small in a contiguous region of not less than 70 area% (preferably not less than 80 area%, more preferably not less than 90 area%) of the epitaxial film 20, as described above. Therefore, the effective area of the semiconductor wafer 1 is not less than 70%, 80%, or not less than 90%, and the manufacturing yield of semiconductor devices can be greatly increased.

### Example

The phenomenon in which "when there is a region in which the off angle in the [010] direction of the growth base substrate 11 is in a range of more than -0.01° and less than 0.01°, linear morphology spreads from a portion of the surface 21 of the epitaxial film 20 which is located on that region" and the phenomenon in which "the deposition rate is low at a portion with linear morphology on the surface 21 of the epitaxial film 20", which are described in the above embodiment, will be described while showing the experimental results.

In addition to the distribution of the off angle in the [010] direction of the growth base surface 11 of the semiconductor substrate 10, factors in the manufacturing process also cause the distribution in the thickness of the epitaxial film 20. Therefore, in this Example, the cause due to the manufacturing method using the HVPE apparatus is firstly removed by correction in order to accurately determine the relationship between the off angle in the [010] direction of the growth base surface 11 and the film thickness distribution of the epitaxial film 20.

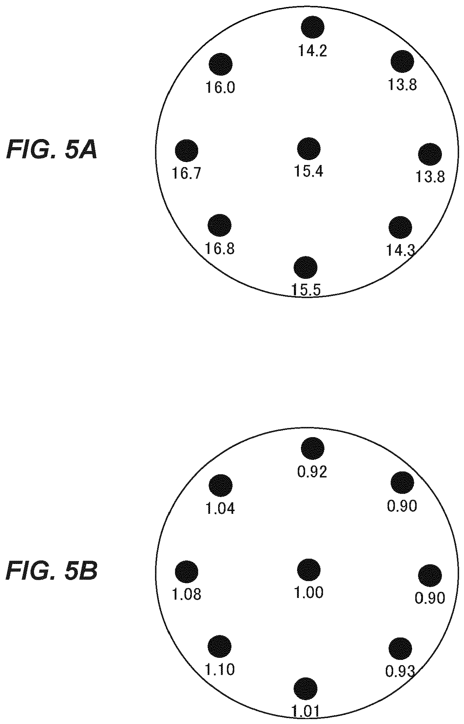

FIG. 5A is a plan view showing a film thickness distribution of a Ga₂O₃ film deposited on a sapphire substrate having a C-plane as a main surface by the HVPE method. The in-plane distribution of the off angle of the sapphire substrate is within ±0.05 degrees, and the off angle of the entire main surface can be regarded as almost 0°. Furthermore, it has been found that the film thickness distribution of a Ga₂O₃ film deposited on a sapphire substrate having a C-plane as a main surface does not substantially depend on the off angle of the sapphire substrate. Therefore, the thickness distribution of the Ga₂O₃ film on the sapphire substrate is almost due to factors in the manufacturing process. In particular, the source gases are supplied onto the substrate from the upper side of the drawing in the reaction chamber of the HVPE apparatus, and the film thickness is larger on the downstream side of the source gas flow (on the lower side of the drawing).

Since the Ga₂O₃ film on the sapphire substrate and the epitaxial film 20 are deposited using the same HVPE apparatus under the same conditions, it is possible to correct the film thickness distribution of the epitaxial film 20 by using the film thickness distribution of the Ga₂O₃ film on the sapphire substrate and extract only the influence of the off angle of the growth substrate surface 11 on the film thickness distribution of the film epitaxial film 20.

FIG. 5B is a plan view showing the film thickness distribution of the Ga₂O₃ film on the sapphire substrate, with the film thickness at the center normalized to 1.00. The normalized film thickness at each point of the Ga₂O₃ film on the sapphire substrate shown in FIG. 5B is used as a corrected value.

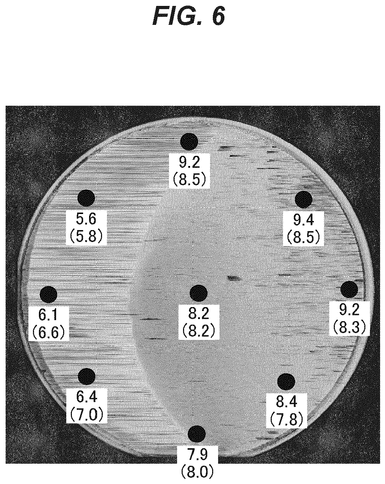

FIG. 6 is a plan view showing the film thickness distribution of the epitaxial film 20 shown in FIG. 2B, which is corrected using the normalized film thickness distribution of the Ga₂O₃ film on the sapphire substrate. At each point in FIG. 6, the numerical value indicates the film thickness after correction (unit: µm), and the numerical value in parentheses indicates the film thickness before correction. The correction is performed by dividing the film thickness at each point of the epitaxial film 20 by the corrected value (the normalized film thickness of the Ga₂O₃ film on the sapphire substrate shown in FIG. 5B).

FIG. 6 shows that the epitaxial film 20 has a smaller film thickness at the portion with linear morphology than other portions.

Next, the experimental results showing the phenomenon in which "the epitaxial film 20 has a higher donor concentration at the portion with linear morphology", which is described in the above embodiment, will be described.

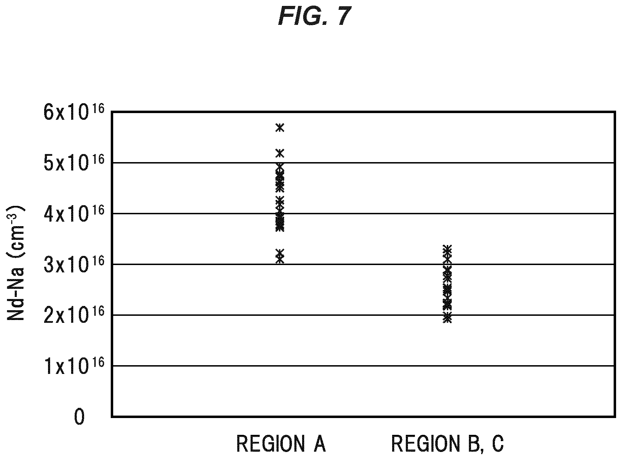

FIG. 7 is a graph showing measured values of the effective donor concentration (Nd-Na) in a region with linear morphology (corresponding to the region A described above) and a region without linear morphology (corresponding to the regions B and C described above) for twenty-five epitaxial films 20. Each of the twenty-five epitaxial films 20 pertain to FIG. 7 is doped with a trace amount of Si at a concentration of about 1×10¹⁶ cm⁻³.

FIG. 7 shows that the donor concentration in the region having linear morphology is generally higher and varies more largely than the donor concentration in the region not having linear morphology. It is considered that this is because the region having linear morphology easily incorporates an impurity (presumably Cl included in the raw material of the HVPE method) that acts as a donor.

Although the embodiment and Example of the invention have been described, the invention is not intended to be limited to the embodiment and Example, and the various kinds of modifications can be implemented without departing from the gist of the invention. In addition, the constituent elements in the embodiment and Example can be arbitrarily combined without departing from the gist of the invention.

In addition, the invention according to claims is not to be limited to the embodiment and Example described above. Further, it should be noted that not all combinations of the features described in the embodiment and Example are necessary to solve the problem of the invention.

### Industrial Applicability

Provided are a gallium oxide-based semiconductor substrate on which a gallium oxide-based epitaxial film having a small film thickness distribution, a small donor concentration distribution, and a low crystal defect density can be deposited by the HVPE method, a semiconductor wafer including such semiconductor substrate and epitaxial film, and a method for manufacturing such a semiconductor wafer.

### Reference Signs List

1 SEMICONDUCTOR WAFER
10 SEMICONDUCTOR SUBSTRATE
11 GROWTH BASE SURFACE
20 EPITAXIAL FILM
21 SURFACE

## Claims

1. A semiconductor substrate, comprising:
at least one main surface as a crystal growth base surface; and
a gallium oxide-based semiconductor single crystal,
wherein the growth base surface is a (001) plane,
wherein an off angle in a [010] direction in a continuous region of not less than 70 area% of the growth base surface is in a range of more than -0.3° and not more than -0.01°, or in a range of not less than 0.01° and less than 0.3°,
wherein an off angle in a [001] direction in the region of the growth base surface is in a range of not less than -1° and not more than 1°, and
wherein the semiconductor substrate has a diameter not less than 2 inches.

2. A semiconductor wafer, comprising:
the semiconductor substrate according to claim 1; and
an epitaxial film on the growth base surface of the semiconductor substrate, the epitaxial film comprising a single crystal of a gallium oxide-based semiconductor which comprises Cl derived from a raw material of the HVPE method,
wherein a density of crystal defects appearing as etch pits in the epitaxial film is less than 5×10⁴ cm⁻³.

3. The semiconductor wafer according to claim 2, wherein the epitaxial film is in an as-grown state, and wherein a film thickness distribution in a continuous region of not less than 70 area% of the epitaxial film is less than ±10%.

4. The semiconductor wafer according to claim 2 or 3, wherein the epitaxial film does not include an intentionally added donor, and wherein a donor concentration distribution in the epitaxial film is less than ±40%.

5. The semiconductor wafer according to any one of claims 2 to 4, wherein an in-plane density of pits reaching from the surface of the epitaxial film to a surface of the semiconductor substrate in a continuous region of not less than 70 area% of a surface of the epitaxial film is not more than 0.1 pit/cm².

6. A method for manufacturing a semiconductor wafer, comprising:
preparing a semiconductor substrate comprising at least one main surface as a crystal growth base surface, the semiconductor substrate comprising a gallium oxide-based semiconductor single crystal and having a diameter of not less than 2 inches; and
forming an epitaxial film by epitaxially growing a gallium oxide-based semiconductor single crystal on the growth base surface of the semiconductor substrate using a HVPE method,
wherein the growth base surface is a (001) plane,
wherein an off angle in a [010] direction in a continuous region of not less than 70 area% of the growth base surface is in a range of more than -0.3° and not more than -0.01°, or in a range of not less than 0.01° and less than 0.3°, and
wherein an off angle in a [001] direction in the region of the growth base surface is in a range of not less than -1° and not more than 1°.
